# EUROPÄISCHE PATENTSCHRIFT

(11) **EP 1 212 726 B1**
(45) Veröffentlichungstag und Bekanntmachung des Hinweises auf die Patenterteilung: **16.03.2005**
(21) Anmeldenummer: 00965790.9
(22) Anmeldetag: 24.08.2000
(51) Int. Cl.: G06K 19/077

(54) **VERFAHREN ZUR HERSTELLUNG EINES CHIPKARTENMODULS**
METHOD FOR PRODUCING A CHIP CARD MODULE
PROCEDE DE PRODUCTION D'UN MODULE DE CARTE A PUCE

(30) Priorität: 26.08.1999 DE 19940564
(43) Veröffentlichungstag der Anmeldung: 12.06.2002
(73) Patentinhaber: Infineon Technologies AG, 81669 München (DE)
(72) Erfinder: PÜSCHNER, Frank, D-93309 Kelheim (DE); HEINEMANN, Erik, D-93049 Regensburg (DE); FISCHER, Jürgen, D-93180 Deuerling (DE)
(74) Vertreter: Epping Hermann & Fischer
(86) Internationale Anmeldenummer: PCT/DE2000/002898
(87) Internationale Veröffentlichungsnummer: WO 2001/016875

(56) Entgegenhaltungen:
- EP-A- 0 772 232
- EP-A- 0 930 651
- DE-A- 19 708 617
- DE-C- 19 532 755

## Beschreibung

Die Erfindung betrifft ein Verfahren zur Herstellung eines Chipkartenmoduls.

Chipkartenmodule bestehen üblicherweise aus einem Träger, beispielsweise einer laminierten Kunststoffolie oder einem metallischen Anschlußrahmen (Leadframe) , auf welchem ein Halbleiterchip befestigt ist. Die leitfähigen Schichten bzw. Bestandteile des Trägers sind zu einzelnen Kontaktflächen strukturie:rt, die mit einem Karten-Lesegerät abgegriffen werden können. Die Form und Größe der üblicherweise in einer Anschlußebene angeordneten Kontaktflächen richtet sich in der Regel nach bestimmten Normvorgaben wie beispielsweise dem ISO-Standard 7816. Halbleiterchip und Kontaktflächen sind in herkömmlichen Chipkartenmodulen mit Hilfe von Bonddrähten, die von den Kontaktierungsstellen des Halbleiterchips zu den Anschlußstellen der Kontaktflächen geführt sind, elektrisch kontaktiert. Alternativ kann der Halbleiterchip in Flip-Chip-Technik aufgebracht sein.

Zum Schutz des Chips und der Verbindungen zu den Kontaktflächen wird über dem Chip und den Verbindungsstellen eine Schicht aus Epoxidharz, duroplastischem Kunststoff oder ähnlichem aufgebracht. Der fertige Chipkartenmodul, der im allgemeinen eine Bauteilhöhe von mindestens 500-600 *µ*m besitzt, wird schließlich in den Kartenträger einer Chipkarte implantiert.

Aus der DE 197 08 617 A1 ist ein Chipkartenmodul der eingangs genannten Art bekannt, bei dem der Halbleiterchip nicht als zunächst "nackter" Chip eingebaut und, wie oben beschrieben, erst danach, also im Chipkartenmodul gehäust wird, sondern als sogenanntes Die-Size-Package, heute meist Chip-Size-Package (CSP) genannt, eingebaut wird. Diese Packages sind bereits mit einer Schutzschicht und mit Anschlußflächen versehen und erlauben kleinere Moduldicken. Dabei ist auch bekannt, für die Montage ein Anschlußrahmenband zu verwenden, aus dem die einzelnen Chipkartenmodule erst nach Positionierung, Aufsetzen und Kontaktierung der - offenbar als fertig vorausgesetzten - Die-Size-Packages auf den jeweiligen Kontaktflächen herausgetrennt werden.

Aus der EP-A-0 930 651 ist ein Chipkartenmodul bekannt, bei dem ein Halbleiterchip und ein eine Anschlußebene aufweisender Träger elektrisch miteinander verbunden und zusammen von einer Vergußmasse umgeben sind.

Die EP-A-0 772 232 offenbart ein Chipkartenmodul, das ähnlich wie das aus der EP-A-0 930 651 ausgestaltet ist. Auf der Kontaktierungsstellen aufweisenden Seite des Halbleiterchips ist eine Schutzschicht vorgesehen, durch die Flip-Chip-Bumps hindurchreichen. Der mit einem Kontakflächen aufweisenden Träger elektrisch verbundene Halbleiterchip ist zusammen mit dem Träger von einer Vergußmasse umgeben.

Für die Herstellung und den Aufbau derartiger extra gehäuster Chips bzw. die Integration von deren Herstellung in den Montageablauf der Chipkartenmodule gibt es viele Möglichkeiten, deren Vor- und Nachteile abgewogen werden müssen. Im Zuge der immer größeren Funktionsvielfalt und den damit immer größer werdenden Chips steigen nicht nur die Forderungen nach kleineren Moduldicken, sondern auch die an die mechanische Robustheit. Mit größer werdenden CSP-ähnlichen Gehäusen, die während der Herstellung an ein Anschlußrahmenband gekoppelt wären, würde zwangsläufig auch die Ausnutzung von Trägerband und Spritzmaschine schlechter.

Ziel der vorliegenden Erfindung ist es, einen Chipkartenmodul der eingangs genannten Art zu schaffen, der einfach und effektiv herzustellen ist und der geringe Bauteilabmessungen aufweist. Der Halbleiterchip sollte dabei auch gut gegen mechanische Beschädigung und chemische Einflüsse geschützt sein. Zugleich soll mit der Erfindung ein Verfahren angegeben werden, um einen solchen Chipkartenmodul fertigungsoptimiert herzustellen. Außerdem sollte sich der erfindungsgemäße Chipkartenmodul für den Einbau in eine Chipkarte verwenden lassen.

Ein erfindungsgemäßes Verfahren zur Herstellung eines derartigen Chipkartenmoduls sieht vor,
- daß ein Halbleiterchip mit seiner Kontaktierungsstellen gegenüberliegenden Unterseite auf einem Trägerelement befestigt wird, und daß Flip-Chip-Bumps, insbesondere Studbumps, aus duktilem Material auf den Kontaktierungsstellen des Chips aufgebracht werden,
- daß der Chip mit den Bumps anschließend in ein geöffnetes Spritzgießwerkzeug transportiert wird, dessen obere Werkzeughälfte eine flächig ausgebildete, den Bumps zugewandte Innenwand umfaßt,
- die beim darauf folgenden Schließen des Spritzgießwerkzeugs die Bumps von deren vom Chip abgewandten Enden her bis zu einer Höhe zusammendrückt, die der Dicke einer auf die Oberseite des Chip zu spritzenden Abdeckmasse entspricht,
- woraufhin durch Einspritzen eines Kunststoffs in das geschlossene Spritzgießwerkzeug der Chip und die Bumps, nicht jedoch deren plangedrückte, Anschlußflächen bildende Enden, bis zum Trägerelement hinunter mit der Abdeckmasse umhüllt werden,
- und daß im weiteren Verlauf die Bereitstellung der Kontaktflächen der Anschlußebene und deren Ankontaktierung an die Anschlußflächen erfolgt.

Die Erfindung beruht zunächst darauf, daß nur der Chip selbst abgedeckt: wird. Die Schutzschicht bzw. das Gehäuse ist demnach kaum größer als der Chip selbst, und somit äußerst robust. Andererseits kann die Entflechtung und Bereitstellung der Kontaktflächen zu einem späteren Zeitpunkt erfolgen. Durch diese Entkopplung können Trägerband (für die zu umhüllenden Chips) und Multiplunger (Mehrfachspritzgießgerät) optimal genutzt werden. Die Anzahl der Module/Maschinentakt ist um ein vielfaches größer. Etwa 300 Chips können pro Schuß gleichzeitig abgedeckt werden.

Die Bereitstellung der Kontaktflächen kann später entweder in der Chipkarte über gesputterte oder gedruckte Kontaktflächen, oder durch Aufsetzen des CSP auf ein stanz-oder ätztechnisch hergestelltes Metallleadframe erfolgen. Die Kontaktierung erfolgt erfindungsgemäß nicht über Wire-bonds, sondern über Flip-Chip-Bumps. Die Bumps können mit allen bei Flip-Chip-Technik üblichen Verfahren aufgebracht werden. Erfindungsgemäß wird vorteilhaft ein an sich bekannter Studbump aufgebracht. Dazu kann z.B. ein Gold-Draht verwendet werden. Dieser läßt sich mit ca. 70-80 *µ*m Höhe aufbringen. Beim Molden wird der Bump auf ca. 20 *µ*m zusammengedrückt. Damit entsteht einerseits die gewünschte, plangedrückte Anschlußfläche (Pad) und gleichzeitig eine Dichtfläche, um den sogenannten Bleed und Flash auf der Au-Oberfläche zu verhindern. Das restliche verdrängte Material bildet das Anschlußpad für den Kontakt zur Kontaktfläche.

Weiterbildungen und bevorzugte Maßnahmen ergeben sich aus den Unteransprüchen.

Die Erfindung wird nachfolgend an Ausführungsbeispielen anhand der Zeichnungen näher erläutert. Es zeigt
- Figur 1: schematisch ein erfindungsgemäßes Chipkartenmodul im Querschnitt,
- Figur 2: schematisch in schräger Draufsicht ein Chipkartenmodul gemäß Figur 1, jedoch mit anderen Kontaktflächen,
- Figur 3 und 4: schematisch einen seitlichen Querschnitt eines Spritzgießwerkzeugs, das ein unfertiges Chipkartenmodul enthält, jeweils im geöffneten bzw. geschlossenen Zustand,
- Figur 5: einen schematischen seitlichen Querschnitt eines noch an einem Trägerband befestigten Chipkartenmoduls.

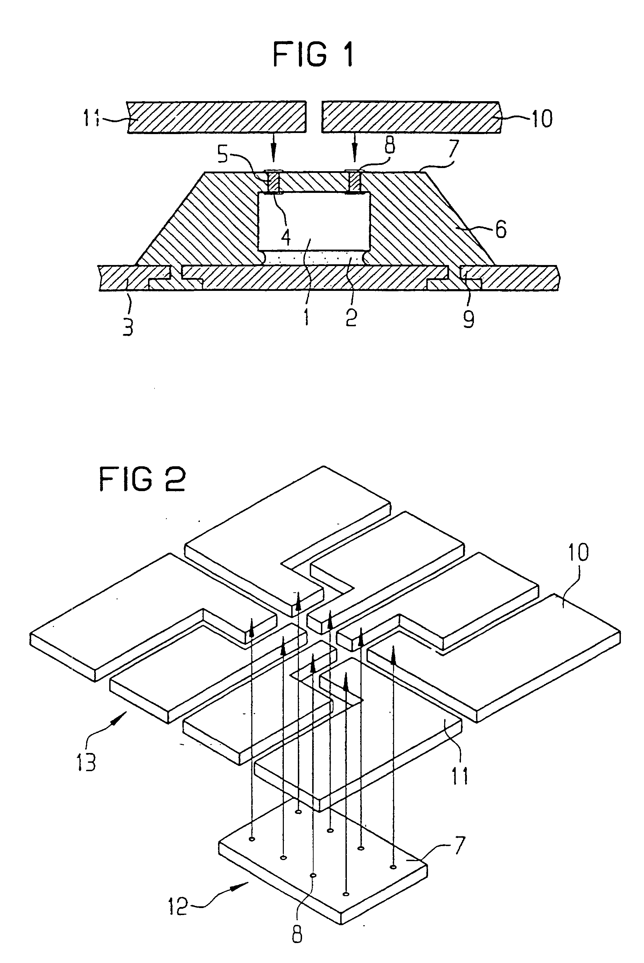

Der in Figur 1 dargestellte Chipkartenmodul umfaßt einen Halbleiterchip 1, der mit Klebstoff 2 auf ein Trägerband 3 geklebt ist. Der Chip 1 und die auf seinen oberseitigen Kontaktierungsstellen 4 aufgebrachten Bumps 5 sind in bereits fertig abgedecktem Zustand dargestellt. Die oberen Enden der während des Abdeckprozesses (siehe weiter unten) flachgedrückten Bumps 5 liegen planparallel in der vom Chip 1 abgewandten Oberfläche 7 der Abdeckmasse 6 und bilden jeweils eine Anschlußfläche 8.

Da das hier beispielsweise als Leadframe ausgeführte Trägerband 3 nur als Trägermaterial für die Häusung des Chips 1 dient, ist ebensogut der Einsatz eines Trägerelements aus Kunststoff möglich, sofern dieser für den Abdeckprozess geeignet ist. Das als Metallleadframe ausgeführte Trägerband 3 gemäß Figur 1 bietet jedoch den zusätzlichen Vorteil, daß es, wie in Figur 1 dargestellt, mit Prägungen 9 auf der Rückseite versehen werden kann. Dadurch haftet die Abdeckmasse 6 nicht nur auf der Oberseite des Trägerbandes 3, sondern sie wird am Trägerband 3 mechanisch noch besser verankert. Gemäß Figur 1 kann der Chipkartenmodul von der Oberseite her mit gesputterten Kontaktflächen 10 und 11 fertiggestellt werden, die nur der Darstellung halber mit Abstand zur Oberfläche 7 gezeigt sind, tatsächlich aber mit unmittelbarem Kontakt zu den jeweiligen Anschlußflächen 8 angeordnet sind, also eine an die Oberfläche 7 angrenzende Anschlußebene bilden.

In Figur 2 ist ein fertig abgedeckter Chip dargestellt, dessen kontaktflächenseitige Mold-Oberfläche 7 von acht in zwei Reihen angeordneten Anschlußflächen 8 durchsetzt ist. Diese Einheit 1.2 kann mit den Anschlußflächen 8 voran auf die dargestellten acht Kontaktflächen 10 und 11 eines Anschluß-Leadframes 13 aufgesetzt werden, das zunächst in einem Kontaktträgerband integriert sein kann, ebenso wie die Einheit 12 mittels ihres Trägerelements noch in ein Trägerband 3 integriert sein kann. Die Anzahl und Anordnung der Kontaktflächen 10, 11 hängt ab von der Anzahl und Lage der Bumps 5 bzw. der Anschlußflächen 8.

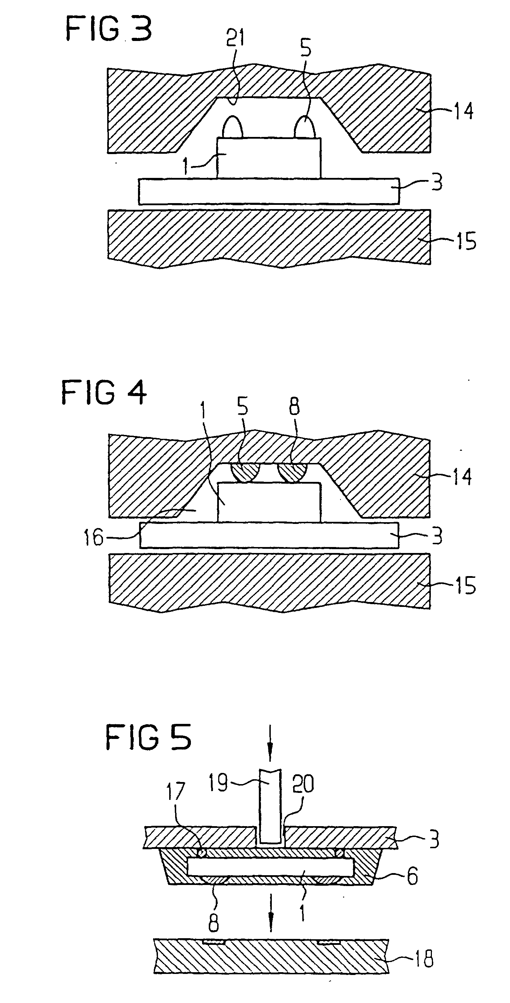

In Figur 3 ist ein auf einem Trägerband 3 befestigter und auf seiner Oberseite mit zunächst ca. 80 *µ*m hohen Bumps 5 versehener Chip 1 innerhalb der noch geöffneten Werkzeughälften 14, 15 eines Spritzgießwerkzeugs dargestellt. In Figur 4 ist der Zustand nach Schließen, d.h. nach Herunterfahren der oberen Werkzeughälfte 14, erkennbar. Die Bumps 5 wurden durch die Innenwand 21 auf eine Höhe von ca. 20 *µ*m zusammengedrückt und auf ihrer Oberseite, wie gewünscht, zu nahezu planen Anschlußflächen 8 verformt. Der eigentliche Einspritz- bzw. Umhüllprozess erfolgt im Werkzeugzustand gemäß Figur 4. Verwendet wird beispielsweise ein leicht fließender Thermoplast, der mit hohem Druck in den Innenraum 16 des Spritzgießwerkzeugs 14, 15 eingespritzt wird.

Da das Leadframe oder allgemeiner das Trägerband 3 nur für den Abdeckprozess des Chips 1 benötigt wird, eröffnet sich die Möglichkeit seiner späteren Entfernung. Danach können die Gehäuse, also die Einheiten 12, über einen Ejektor oder über eine Rolle als Schüttgut vereinzelt werden. Die Anbindung des Chips 1 an das Trägerband 3 kann beispielsweise über Klebstoffpunkte 17, vergleiche Figur 5, erfolgen.

Denkbar ist auch die Zusammenführung von Trägerband 3 für den Chip 1 und Kontaktträgerband 18, vgl. Figur 5. Der Gehäusechip, (Einheit 12 ) wird über dem Kontaktträgerband 18 in Position gebracht und von hinten mittels eines Ejektors 19 ausgestoßen und gleich danach auf dem Kontaktträgerband 18 fixiert. Um die Ausstoßkraft zu minimieren, kann, wie in Figur 5 dargestellt, das Trägerband 3 für den Chip 1 zusätzlich mit Löchern 20 unter dem Chip 1 versehen werden. Bei großen Chips 1 kann durch diese Löcher 20 der Ejektor 19 stoßen.

Für Anwendungen, bei denen eine besonders gute Haftung zwischen den Anschlußflächen 8 und dem Kontaktträgerband 18 erforderlich ist, kann dies durch einfache zusätzliche Maßnahmen erreicht werden. Einerseits ist es möglich, das Gehäuse, also die Oberfläche 7 der Abdeckmasse 6 zu vergrößern. Dadurch wird zusätzliche Klebefläche bereitgestellt, die mittels eines geeigneten Klebstoffes ausgenützt werden kann. Der Klebstoff ist abhängig von dem gewählten Kontaktträgerband 18 Die größere Abdeckung verschlechtert allerdings auch geringfügig die optimale Ausnutzung von Trägerband 3 und Multiplunger. Alternativ kann in einem zusätzlichen Prozessschritt auf die Anschlußflächen 8 noch eine ca-. 20 *µ*m dicke galvanische Beschichtung aufgebracht werden, wobei ein Haftvermittler erforderlich wird. Die Abscheidung der galvanischen Beschichtung erfolgt stromlos. Auch eine zusätzlicher Sputterprozess ist möglich.

Erfindungsgemäß resultieren Schutzgehäuse 6, die kaum (zu jeder Seite nur ca. 0,2 mm) größer als der Chip 1 selbst sind und damit eine optimale Ausnutzung von Trägerband und Spritzmaschinen gewährleisten. Die Bumps werden nur teilweise, d.h. nur an ihren Seiten, nicht jedoch an den plangedrückten, Anschlußflächen bildenden Oberseiten abgedeckt. Dies gewährleistet eine optimale Raumausnutzung und gleichzeitig Schutz vor Beschädigungen. Die Bumps werden, wie beschrieben, durch den Moldprozess zu Kontaktpads, also zu Anschlußflächen, geformt. Der erfindungsgemäße Aufbau des Chipkartenmoduls bringt den zusätzlichen Vorteil mit sich, daß die Bumps nicht den bei Flip-Chip-Technik üblichen Scherspannungen ausgesetzt sind. Diese Scherspannungen, die meist zu einem Abreißen in der -Mitte des Bumps führen, werden durch die seitlich abstützende Abdeckmasse verhindert.

Für die Herstellung der Kontaktflächen besteht, wie beschrieben, einerseits die Möglichkeit, den Chip mit Gehäuse als CSP-ähnlichen Baustein zu verwenden und auf eine beispielsweise stanztechnisch hergestellte Kontaktfläche aufzusetzen. Andererseits besteht die Möglichkeit, den Chip mit Gehäuse in die Kavität eines Chipkartenkörpers einzusetzen und die Kontaktflächen in der Chipkarte aufzusputtern oder aufzudrucken.

## Patentansprüche

1. Verfahren zur Herstellung eines Chipkartenmoduls,
**dadurch gekennzeichnet, daß**
- daß ein Halbleiterchip (1) mit seiner Kontaktierungsstellen (4) gegenüberliegenden Unterseite auf einem Trägerelement (3) befestigt wird, und daß Flip-Chip-Bumps (5), insbesondere Studbumps, aus duktilem Material auf den Kontaktierungsstellen (4) des Chips (1) aufgebracht werden,
- daß der Chip (1) mit den Bumps (5) anschließend in ein geöffnetes Spritzgießwerkzeug (14, 15) transportiert wird, das eine obere Werkzeughälfte (14) mit einer flächig ausgebildeten, den Bumps (5) zugewandte Innenwand (21) umfaßt,
- die beim darauf folgenden Schließen des Spritzgießwerkzeugs (14, 15) die Bumps (5) von deren vom Chip (1) abgewandten Enden her bis zu einer Höhe zusammendrückt, die der Dicke einer auf die Oberseite des Chip (1) zu spritzenden Abdeckmasse (6) entspricht,
- woraufhin durch Einspritzen eines Kunststoffs in das geschlossene Spritzgießwerkzeug (14, 15) der Chip (1) und die Bumps (5), nicht jedoch deren plangedrückte, Anschlußflächen (8) bildende Enden, bis zum Trägerelement (3) hinunter mit der Abdeckmasse (6) umhüllt werden,
- und daß im weiteren Verlauf die Bereitstellung der Kontaktflächen (10, 11) der Anschlußebene und deren Ankontaktierung an die Anschlußflächen (8) erfolgt.

2. Verfahren nach Anspruch 1,
**dadurch gekennzeichnet,**
**daß** als Trägerelement ein Trägerband (3) verwendet wird.

3. Verfahren nach Anspruch 2,
**dadurch gekennzeichnet,**
**daß** für die Bereitstellung der Kontaktflächen (10, 11) ein Kontaktträgerband (18) verwendet wird und daß der mit Abdeckmasse (6) umhüllte Chip (1) durch sein Trägerband (3) mit dem Kontaktträgerband (18) zusammengeführt wird.

4. Verfahren nach Anspruch 1 oder 2,
**dadurch gekennzeichnet, daß** für die Bereitstellung von Kontaktflächen (10, 11) dies durch Aufsputtern oder Aufdrucken auf die Anschlußflächen (8) und eine diese umgebende Oberfläche (7) der Abdeckmasse (6) erfolgt.

5. Verfahren nach einem der Ansprüche 1 bis 4,
**dadurch gekennzeichnet,**
**daß** das Trägerelement oder Trägerband (3) nach dem Abdeckprozeß wieder entfernt wird.

6. Verfahren nach Anspruch 5,
**dadurch gekennzeichnet,**
**daß** das Trägerelement oder Trägerband (3) mit einem unter dem Chip (1) befindlichen Loch (20) versehen wird, durch das ein Ejektor (19) stößt und somit den Chip (1) vom Trägerelement oder Trägerband (3) löst.

7. Verfahren nach einem der Ansprüche 1 bis 6,
**dadurch gekennzeichnet,**
**daß** als Trägerelement ein Träger-Leadframe oder als Trägerband (3) ein Träger-Leadframeband (13) verwendet wird.

## Claims

1. Method for producing a smart card module
characterized
- in that a semiconductor chip (1) is fixed by its underside - opposite to the contact-connection points (4) - on a carrier element (3), and in that flip-chip bumps (5), in particular stud bumps, made of ductile material are applied on the contact-connection points (4) of the chip (1),
- in that the chip (1) with the bumps (5) is subsequently transported into an open injection mould (14, 15), which comprises an upper mould half (14) with an areally designed inner wall (21) facing the bumps (5),
- which inner wall, when the injection mould (14, 15) is subsequently closed, compresses the bumps (5) from their ends remote from the chip (1) to a height which corresponds to the thickness of a covering compound (6) that is to be injected onto the top side of the chip (1),
- whereupon, by the injection of a plastic into the closed injection mould (14, 15), the chip (1) and the bumps (5), but not their plane-pressed ends forming pads (8), are encapsulated down to the carrier element (3) with the covering compound (6) ,
- and in that, in the further course of events, the contact areas (10, 11) of the connection plane are provided and contact connected to the pads (8).

2. Method according to Claim 1,
**characterized**
**in that** a carrier strip (3) is used as carrier element.

3. Method according to Claim 2,
**characterized**
**in that** a contact carrier strip (18) is used for providing the contact areas (10, 11), and in that the chip (1) encapsulated with covering compound (6) is brought together with the contact carrier strip (18) by its carrier strip (3).

4. Method according to Claim 1 or 2
**characterized**
**in that**, for providing contact areas (10,11), this is effected by sputtering or printing onto the pads (8) and a surface (7) - surrounding the latter - of the covering compound (6).

5. Method according to one of Claims 1 to 4,
**characterized**
**in that** the carrier element or carrier strip (3) is removed again after the covering process.

6. Method according to Claim 5,
**characterized**
**in that** the carrier element or carrier strip (3) is provided with a hole (20) situated below the chip (1), through which hole an ejector (19) plunges and thus detaches the chip (1) from the carrier element or carrier strip (3).

7. Method according to one of Claims 1 to 6,
**characterized**
**in that** a carrier leadframe is used as carrier element or a carrier leadframe strip (13) is used as carrier strip (3).

## Revendications

1. Procédé pour fabriquer un module de carte à puce,
**caractérisé en ce que**
- par son côté inférieur opposé aux points de contact (4), une puce à semiconducteur (1) est fixée sur un élément de support (3) et que des bossages de puce à surépaisseur (5) en un matériau ductile, en particulier des bossages en plot, sont déposés sur les points de contact (4) de la puce (1),
- la puce (1) munie des bossages (5) est ensuite transportée dans un moule pour injection (14, 15) ouvert comportant une moitié supérieure d'outil (14) qui comprend une paroi intérieure (21) plane et tournée vers les bossages (5) et
- qui, lorsqu'on ferme ensuite le moule pour injection (14, 15), comprime les bossages (5) depuis les extrémités éloignées de la puce (1) jusqu'à une hauteur qui correspond à l'épaisseur d'une masse de recouvrement (6) à injecter sur le côté supérieur de la puce (1),
- puis, en injectant une matière plastique dans le moule pour injection (14, 15) fermé, la puce (1) et les bossages (5), sauf leurs extrémités qui forment les pastilles (8) comprimées à plat, sont enrobés par la masse de recouvrement (6) jusqu'au niveau de l'élément de support (3),
- et que par la suite les surfaces de contact (10, 11) du plan de raccordement sont préparées et mises en contact avec les pastilles (8).

2. Procédé selon la revendication 1, **caractérisé en ce que**
une bande de support (3) sert d'élément de support.

3. Procédé selon la revendication 2, **caractérisé en ce que**
on utilise une bande porte-contact (18) pour préparer les surfaces de contact (10, 11)
et la puce (1) enrobée de la masse de recouvrement (6) est rassemblée avec la bande porte-contact (18) par l'intermédiaire de sa bande de support (3).

4. Procédé selon la revendication 1 ou 2, **caractérisé en ce que**
pour préparer des surfaces de contact (10, 11) on procède par pulvérisation cathodique ou par impression sur les pastilles (8) et sur une surface (7) - de la masse de recouvrement (6) - qui les entourent.

5. Procédé selon l'une des revendications 1 à 4, **caractérisé en ce que**
l'élément de support ou la bande de support (3) est de nouveau retiré après l'opération de revêtement.

6. Procédé selon la revendication 5, **caractérisé en ce que**
l'élément de support ou la bande de support (3) est muni d'un trou (20) situé sous la puce (1) et par lequel un éjecteur (19) expulse et détache par conséquent la puce (1) de l'élément de support ou de la bande de support (3).

7. Procédé selon l'une des revendications 1 à 6, **caractérisé en ce que**
l'élément de support qu'on utilise est une grille de connexion du support ou la bande de support (3) est une bande de grille de connexion (13) du support.
